# EUROPEAN PATENT APPLICATION

(11) **EP 2 058 903 A1**
(43) Date of publication of application: **13.05.2009**
(21) Application number: 07791950.4
(22) Date of filing: 03.08.2007
(51) Int. Cl.: H01R 11/01, C09J 7/02, C09J 9/02, C09J 201/00, H01B 5/16, H01B 13/00, H01R 43/00, H05K 1/14, H05K 3/32, H05K 3/36

(54) **ANISOTROPIC CONDUCTIVE TAPE AND METHOD OF MANUFACTURING IT, CONNECTED STRUCTURE AND METHOD OF CONNECTING CIRCUIT MEMBER BY USE OF THE TAPE**

(30) Priority: 29.08.2006 JP 2006231935; 27.12.2006 JP 2006352195
(71) Applicant: Hitachi Chemical Company, Ltd., Tokyo 163-0449 (JP)
(72) Inventor: TATSUZAWA, Takashi c/o Hitachi Chemical Company Ltd,, Chikusei-shi Ibaraki 308-8524 (JP); KOBAYASHI, Kouji c/o Hitachi Chemical Company Ltd.,, Chikusei-shi Ibaraki 308-8524 (JP); UENO, Katsuyuki, Tokyo 108-0023 (JP)
(74) Representative: Jönsson, Hans-Peter
(86) International application number: PCT/JP2007/065277
(87) International publication number: WO 2008/029580

(57) **Abstract**

The anisotropic conductive tape (1) of the invention is used for electrical connection between opposing circuit electrodes and is provided with a tape-like base material (20) and with multiple adhesive layers (11b, 12b) formed in parallel on the main side of the base material (20) along the lengthwise direction of the base material (20), wherein at least two of the multiple adhesive layers have different structures.

## Description

### Technical Field

The present invention relates to an anisotropic conductive tape and a process for its production, as well as to a connection structure and a circuit member connection method that employ the anisotropic conductive tape.

### Background Art

Connection between circuit members, including connection between semiconductor elements or liquid crystal display elements and circuit boards, is accomplished by known methods, including methods that employ film-like anisotropic conductive connecting members. Specifically, anisotropic conductive connecting members are used for mounting of circuit boards such as printed wiring boards, liquid crystal display (LCD) glass panels, flexible printed boards and the like, as well as semiconductor elements and packages including ICs and LSIs. Such connecting members can establish conduction between opposing electrodes while also maintaining insulation between adjacent electrodes.

Anisotropic conductive connecting members are generally composed of a base material such as a PET (polyethylene terephthalate) film, and an adhesive layer formed on the main side of the base material. The adhesive layer is made of an adhesive composition, and includes a thermosetting resin-containing adhesive component, with conductive particles also added if necessary. The anisotropic conductive connecting member precursor is cut to a prescribed width to form a tape, which is wound up onto a reel and sold as a product.

Anisotropic conductive connecting members are known whose adhesive components are epoxy resins that exhibit high adhesion and high reliability (see Patent document 1, for example). Radical curing adhesives are also of interest because of their high reactivities and short curing times. Radical curing adhesives include those employing acrylate derivatives or methacrylate derivatives together with peroxides as radical polymerization initiators (see Patent documents 2 and 3, for example).
[Patent document 1] Japanese Unexamined Patent Publication HEI No. 1-113480
[Patent document 2] Japanese Unexamined Patent Publication No. 2002-203427
[Patent document 3] International Patent Publication No. WO98/044067

### Disclosure of the Invention

### Problem to be Solved by the Invention

Using the aforementioned radical curing adhesives shortens the time required for connection between circuit members and improves production efficiency for electronic parts and the like. However, when an anisotropic conductive connecting member (hereinafter referred to simply as "connecting member") is used for connection between circuit members, a connection time of several seconds is necessary to ensure sufficient connection reliability. The additional production efficiency that can be achieved simply by increasing the reactivity of the adhesive components is therefore limited.

On the other hand, there is still room for improvement in the structures of connecting members. Multiple circuit members must be adjacently mounted on a circuit board to achieve micronization and higher performance for electronic devices. Connection of multiple circuit members can be accomplished in such cases with a single connecting member by modifying the configuration of the connecting members and the placement of the circuit members. This can minimize the labor required to configure multiple connecting members on the circuit board, and can thus help improve the production efficiency for electronic parts to a greater degree than by increasing the reactivity of the adhesive component as described above.

For cellular phones and car navigation systems, on the other hand, large liquid crystal display screens are preferred. An increased display screen size tends to narrow the width at the perimeter of the circuit board (known as the "frame section"). Consequently, it is becoming more difficult to ensure adequate space for placement of connecting members at the perimeter. Connecting members must therefore be accommodating against these problems as well. As mentioned above, the ability to connect multiple circuit members with a single connecting member allows the connecting section to occupy less space and hence permits mounting of the prescribed circuit members in the limited space of circuit board perimeters.

It is an object of the present invention, which has been accomplished in light of these circumstances, to provide an anisotropic conductive tape that allows efficient connection of multiple circuit members in limited space on circuit boards, as well as a process for its production. It is another object of the invention to provide a connection structure and a circuit member connection method that employ the anisotropic conductive tape:

### Means for Solving the Problem

The anisotropic conductive tape of the invention is used for electrical connection between opposing circuit electrodes and comprises a tape-like base material; and multiple adhesive layers formed in parallel on the main side of the base material and extending along the lengthwise direction of the base material, wherein at least two of the multiple adhesive layers have different constructions.

The multiple adhesive layers in the anisotropic conductive tape of the invention are formed in parallel along the lengthwise direction. By appropriately selecting the construction of each of the adhesive layers in correspondence with the shape of the circuit members to be connected, it is possible to establish connection of the multiple circuit members with a single anisotropic conductive tape. As a result, it is possible to reduce the labor required for placement of the multiple connecting members corresponding to the circuit members on the circuit board, and thus carry out operation more efficiently. Moreover, since multiple circuit members can be connected by a single anisotropic conductive tape, it is possible to minimize space required for the connecting section. Consequently, the connection operation can be satisfactorily accomplished even when space on the circuit board is limited.

At least two adhesive layers among the multiple adhesive layers in the anisotropic conductive tape according to the invention may have different thicknesses and/or adhesive compositions. Also, at least two adhesive layers among the multiple adhesive layers may have different widths in the widthwise direction. In addition, at least one of the multiple adhesive layers may have a laminated structure with multiple laminated layers, and at least one may have a monolayer structure composed of a single layer. The adhesive layer referred to here is a layer comprising multiple laminated layers, where the layers that are in contact have different adhesive compositions.

Each adhesive layer in the anisotropic conductive tape of the invention is formed on a tape-like support, and multiple adhesive layers are preferably formed on the main side of the base material through the support. An anisotropic conductive tape having this construction has increased strength in the lengthwise direction compared to one lacking a support, and therefore elongation and breakage of the anisotropic conductive tape during the connection operation can be adequately prevented. In addition, the handleability of the anisotropic conductive tape can be improved and the productivity for mounting of different circuit members can be improved. Moreover, because the adhesive layers are anchored on a base material that is wider than the individual adhesive layer supports, this allows the direction of thickness and the direction of width to be more easily distinguished.

The adhesive composition in each adhesive layer preferably comprises an adhesive component and conductive particles dispersed in the adhesive component. When conductive particles are dispersed in the adhesive component, it is possible to establish connection between the opposing circuit electrodes of circuit members with a higher degree of connection reliability.

The tape-like base material in the anisotropic conductive tape of the invention preferably has a width that is equal to or greater than the total length of the multiple adhesive layers in the widthwise direction. This will provide non-adhesive layer-formed regions (base material-exposed sections) on the surface of the side of the base material on which the adhesive layers have been formed. An anisotropic conductive tape with base material-exposed sections on the surface of the base material has the advantage of facilitating release of the base material during connection of circuit members and allowing more economical use of the amount of adhesive composition, compared to a tape having multiple adhesive layers that cover the entirety of the base material surface.

The anisotropic conductive tape of the invention may have base material-exposed sections (first base material-exposed sections) consisting of regions without adhesive layer formation, on the surface of the side of the base material on which the adhesive layers have been formed, and the base material-exposed sections may be situated at both edges in the widthwise direction of the base material along the lengthwise direction of the base material. In this case, the base material-exposed sections situated at both edges in the widthwise direction of the tape-like base material may have different widths as well.

The anisotropic conductive tape of the invention may have at least a pair of adjacent adhesive layers formed in isolation from each other. In this case, base material-exposed sections (second base material-exposed sections) consisting of regions where the adhesive layers are not formed between the pair of adhesive layers formed in isolation, will extend in the lengthwise direction of the base material. When the constructions of the multiple adhesive layers differ only in their thicknesses in the widthwise direction, the adjacent adhesive layers are preferably formed in mutual isolation from the viewpoint of economizing usage of the adhesive composition.

The anisotropic conductive tape of the invention is preferably further provided with a tape-like protective material formed covering the surfaces of the multiple adhesive layers. By covering the surfaces of the adhesive layers with a tape-like protective material, it is possible to prevent adhesion of moisture or foreign matter such as dust in the air onto the adhesive layers and thus minimize deterioration of the adhesive layers.

The anisotropic conductive tape of the invention is produced by a production process comprising an element preparation step, a base material tape preparation step and an element anchoring step. The element preparation step is a step of preparing a plurality of adhesive layer elements each comprising a tape-like support and an adhesive layer formed on the main side of the support. The base material tape preparation step is a step of preparing a base material tape comprising a tape-like base material with a width equal to or greater than the total of the widths of the multiple adhesive layer elements, and a pressure-sensitive adhesive layer formed on the main side of the base material. The element anchoring step is a step of placing and anchoring the multiple adhesive layer elements on the pressure-sensitive adhesive layer in such a manner that the pressure-sensitive adhesive layer is oriented in contact with the back side of the support and each of the adhesive layers extends in the lengthwise direction of the pressure-sensitive adhesive layer. The back side of the support is the side of the support on which the adhesive layers are not formed.

The anisotropic conductive tape may also be produced so as to form a rolled body, in the following manner. Specifically, the anisotropic conductive tape of the invention may be produced by a production process comprising a rolled element preparation step, a rolled base material tape preparation step and a rolled body fabrication step. The rolled element preparation step is a step of preparing a plurality of rolled elements each obtained by rolling around a core an adhesive layer element comprising a tape-like support and an adhesive layer formed on the main side of the support. The rolled base material tape preparation step is a step of preparing a rolled base material tape obtained by rolling around a core a base material tape comprising a tape-like base material with a width equal to or greater than the total of the widths of the multiple adhesive layer elements, and a pressure-sensitive adhesive layer formed on the main side of the base material. The rolled body fabrication step is a step of pulling out the starting edges of the plurality of rolled elements and the rolled base material tape and rolling the multiple adhesive layer elements around a core while anchoring them on the base material tape, in such a manner that the pressure-sensitive adhesive layer and back side of the support are oriented in contact, with each of the adhesive layer elements extending in parallel in the lengthwise direction of the base material tape.

The connection structure of the invention is constructed in the following manner, using an anisotropic conductive tape of the invention. Specifically, the connection structure of the invention comprises a first circuit member having a plurality of first circuit electrodes formed on its main side, a plurality of second circuit members each provided with a second circuit electrode to be connected to the first circuit member, on the surface facing the first circuit member, and a connecting member formed between the first circuit member and the plurality of second circuit members. The connecting member is composed of cured multiple adhesive layers of an anisotropic conductive tape according to the invention, the cured layers being cured by heat pressurization of each adhesive layer while they are situated between the first circuit member and the plurality of second circuit members, and it establishes electrical connection between the opposing first circuit electrodes and second circuit electrodes.

The anisotropic conductive tape of the invention may have two adhesive layers formed in parallel on the main side of the base material, and such an anisotropic conductive tape can be used to produce a connection structure according to the invention. Specifically, the connection structure of the invention comprises a circuit board having first and second circuit electrodes formed on the main side, a first circuit member provided with a third circuit electrode opposing the first circuit electrode on the side facing the circuit board, a second circuit member provided with a fourth circuit electrode opposing the second circuit electrode on the side facing the circuit board, a first connecting member provided between the circuit board and the first circuit member that forms an electrical connection between the first circuit electrode and third circuit electrode, and a second connecting member provided between the circuit board and the second circuit member that forms an electrical connection between the second circuit electrode and fourth circuit electrode. The first connecting member is composed of the cured product of one of the adhesive layers of an anisotropic conductive tape having two adhesive layers. The second connecting member is composed of the cured product of the other of the adhesive layers of the anisotropic conductive tape.

In the circuit member connection method of the invention, one adhesive layer of the aforementioned anisotropic conductive tape of the invention is situated between a first circuit member with a plurality of first circuit electrodes formed on its main side and each of a plurality of second circuit members provided with respective second circuit electrodes that are to be connected to the plurality of first circuit electrodes, on the side facing the first circuit member, and the stack is heated and pressed to cure each adhesive layer, thereby bonding the first circuit member with the plurality of second circuit members in such a manner that the first circuit electrodes and second circuit electrodes are electrically connected.

Since the circuit member connection method of the invention employs the aforementioned anisotropic conductive tape of the invention, it is possible to minimize labor required for placement of multiple connecting members on the circuit board corresponding to each circuit member, and thus improve working efficiency.

The anisotropic conductive tape used in the circuit member connection method of the invention may consist of two adhesive layers provided in parallel, or for example, a COG mounting adhesive layer and FOG mounting adhesive layer provided in parallel. By using such an anisotropic conductive tape, it is possible to attach two adhesive layers in limited space even when the perimeter of the circuit board is narrow, thus permitting more efficient COG mounting and FOG mounting.

### Effect of the Invention

According to the invention, it is possible to provide an anisotropic conductive tape that allows efficient connection of multiple circuit members in limited space on circuit boards, as well as a process for its production. According to the invention it is also possible to provide a connection structure and a circuit member connection method that employ the anisotropic conductive tape.

### Brief Description of the Drawing

Fig. 1 is a perspective view showing a first embodiment of an anisotropic conductive tape according to the invention.
Fig. 2 is a cross-sectional view of the anisotropic conductive tape of Fig. 1 along line II-II.
Fig. 3 is a perspective view showing an anisotropic conductive tape wound onto a reel.
Fig. 4 is a simplified side view of a winding apparatus used for production of an anisotropic conductive tape.
Fig. 5 is a cross-sectional view showing an anisotropic conductive tape situated on a glass panel.
Fig. 6 is a cross-sectional view showing an anisotropic conductive tape pre-contact bonded on a glass panel.
Fig. 7 is a cross-sectional view showing an adhesive layer exposed on a glass panel.
Fig. 8 is a cross-sectional view showing connection of a circuit member onto a glass panel.
Fig. 9 is a cross-sectional view showing an embodiment of a connection structure according to the invention.
Fig. 10 is a cross-sectional view showing a second embodiment of an anisotropic conductive tape according to the invention.
Fig. 11 is a cross-sectional view showing a third embodiment of an anisotropic conductive tape according to the invention.
Fig. 12 is a cross-sectional view showing a fourth embodiment of an anisotropic conductive tape according to the invention.
Fig. 13 is a cross-sectional view showing a fifth embodiment of an anisotropic conductive tape according to the invention.
Fig. 14 is a cross-sectional view showing a sixth embodiment of an anisotropic conductive tape according to the invention.
Fig. 15 (a)-(c) are cross-sectional views showing seventh to ninth embodiments of an anisotropic conductive tape according to the invention.
Fig. 16 (d)-(f) are cross-sectional views showing tenth to twelfth embodiments of an anisotropic conductive tape according to the invention.
Fig. 17 (a)-(c) are cross-sectional views showing other embodiments of an anisotropic conductive tape according to the invention.

### Explanations of Numerals

1A-9A, 1B-6B: Anisotropic conductive tapes, 11, 12: adhesive layer elements, 11A, 12A: rolled elements, 11a, 12a, 13a: supports, 11b, 12b, 13b: adhesive layers, 11c, 12c: cured products, 20: base material, 20A: rolled base material tape, 20a: pressure-sensitive adhesive layer, 20b, 20c: base material-exposed sections, 21: main side, 30: protective material, 31, 32: conductive particles, 50: glass panel (circuit board), 51a, 51b, 52, 72: electrodes (circuit electrodes), 61a, 61b: terminals (circuit electrodes), 100: connection structure, 60: driver IC (circuit member), 70: FPC (circuit member).

### Best Modes for Currying Out the Invention

Preferred embodiments of the invention will now be explained in detail, with reference to the accompanying drawings. Throughout the explanation of the drawings, corresponding elements will be referred to by like reference numerals and will be explained only once. For convenience of illustration, the dimensional proportions in the drawings may not match those explained in the text.

### (First embodiment)

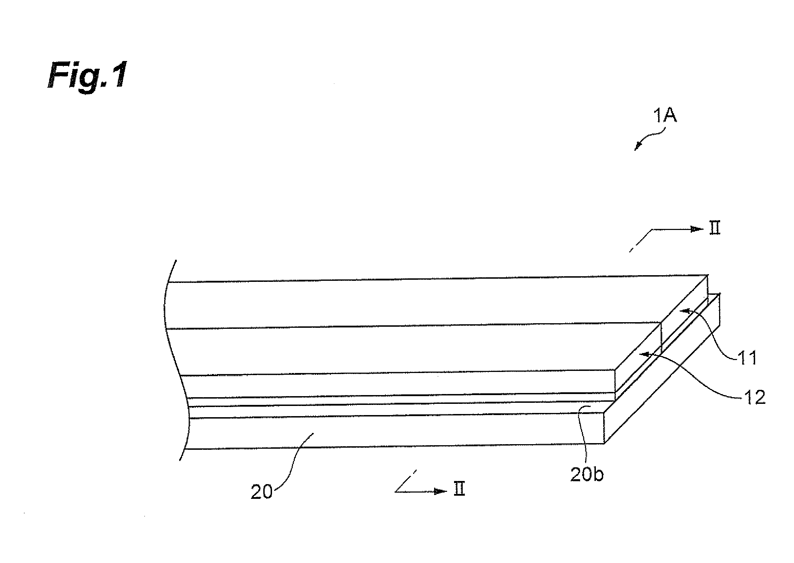

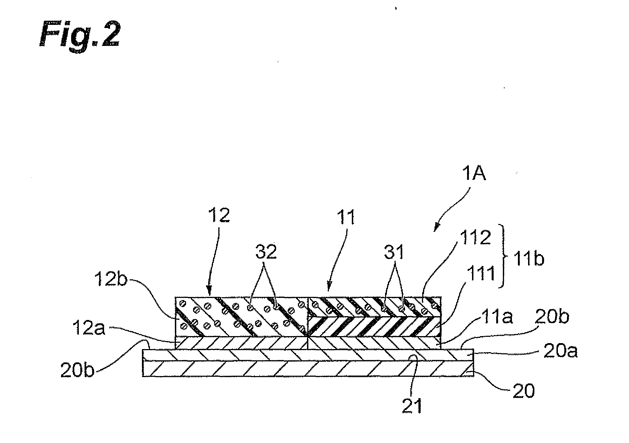

A first embodiment of an anisotropic conductive tape according to the invention will be explained first, with reference to Figs. 1 and 2. The anisotropic conductive tape 1A shown in Figs. 1 and 2 is used when a driver IC (semiconductor chip) and flexible printed circuit board (FPC) are mounted on the perimeter of a glass panel for an LCD, and it serves for electrical connection and mounting of the driver IC and FPC on the glass panel.

Fig. 1 is a perspective view showing an anisotropic conductive tape 1A according to this embodiment. Fig. 2 is a cross-sectional view of the anisotropic conductive tape 1A shown in Fig. 1, along line II-II. The anisotropic conductive tape 1A comprises a tape-like base material 20 and two adhesive layer elements 11, 12 formed in parallel on the main side 21 of the base material 20 along the lengthwise direction of the base material 20. The base material 20 has a pressure-sensitive adhesive layer 20a on the main side 21, and the adhesive layer elements 11, 12 are anchored by the pressure-sensitive adhesive force of the pressure-sensitive adhesive layer 20a. The adhesive layer elements 11, 12 are laid so that one side of each is in contact therewith and anchored by the pressure-sensitive adhesive layer 20a.

The adhesive layer element 11 is composed of a tape-like support 11a and an adhesive layer 11b provided on one side of the support 11a. Likewise, the adhesive layer element 12 is composed of a tape-like support 12a and an adhesive layer 12b provided on one side of the support 12a. The adhesive layer elements 11, 12 are situated in such a manner that the supports 11a, 12a contact with the pressure-sensitive adhesive layer 20a of the base material 20.

Constructions of the anisotropic conductive tape 1A will now be explained. In the anisotropic conductive tape 1A, the adhesive layer 11b is used for COG (Chip On Glass) mounting of a driver IC on an LCD glass panel. The adhesive layer 12b is used for FOG (Film On Glass) mounting of an FPC on an LCD glass panel. The FPC serves for input of electrical current to the LCD glass panel.

The base material 20 is in the form of a tape. The base material 20 has a length of, for example, about 0.1-200 m, a thickness of, for example, about 4-200 µm and a width of, for example, about 1-30 mm. The base material 20 used may be a tape made of, for example, polyethylene terephthalate, polyethylene naphthalate, polyethylene isophthalate, polybutylene terephthalate, polyolefin, polyacetate, polycarbonate, polyphenylene sulfide, polyamide, ethylene-vinyl acetate copolymer, polyvinyl chloride, polyvinylidene chloride, synthetic rubber, liquid crystal polymer or the like. The material of the base material 20 is not limited to these, of course.

The pressure-sensitive adhesive layer 20a on the main side 21 of the base material 20 may be formed using a conventionally known coating applicator, such as a roll coater. When the anisotropic conductive tape 1A is used, the anisotropic conductive tape 1A is attached to the prescribed position of the glass panel in such a manner that the adhesive layers 11b, 12b and circuit board are in contact, and then the base material 20 and the supports 11a, 12a of the adhesive layer elements 11, 12 are released together. From the viewpoint of manageability for this step, the pressure-sensitive adhesive composition composing the pressure-sensitive adhesive layer 20a preferably has a pressure-sensitive adhesive property allowing satisfactory anchoring of the supports 11a, 12a. In order to improve the adhesive strength between the base material 20 and the supports 11a, 12a, a primer layer may be formed between the base material 20 and the supports 11a, 12a or the contact sides of the base material 20 and the supports 11a, 12a may be subjected to plasma treatment or treatment for physical roughening of the surface.

As mentioned above, the adhesive layer elements 11, 12 are each composed of a tape-like support (11a, 12a) and an adhesive layer (11b, 12b) provided on one side of the support.

The supports 11a, 12a are both in the form of tapes. The supports 11a, 12a, like the base material 20, have lengths of, for example, about 0.1-200 m and thicknesses of, for example, about 4-200 µm. The widths of the supports 11 a, 12a, however, are each about 0.5-5 mm, for example. For parallel placement of the two adhesive layer elements 11, 12 on the main side 21 of the base material 20, the total width of the adhesive layer elements 11, 12 is preferably no greater than the width of the base material 20. From the viewpoint of ensuring manageability during connection and strength in the lengthwise direction of the anisotropic conductive tape 1A, the total thickness of the base material and supports is preferably 20-300 µm.

If the total width of the adhesive layer elements 11, 12 is smaller than the width of the base material 20, it will be possible to leave base material-exposed sections (first base material-exposed sections) 20b lacking the adhesive layer, on the surface of the side of the base material 20 on which the adhesive layer elements 11, 12 have been formed. According to this embodiment, the base material-exposed sections 20b extend in the lengthwise direction of the base material 20 at both edges in the widthwise direction of the base material 20, as shown in Fig. 1 and Fig. 2. Forming base material-exposed sections 20b at the both edges in this manner has the advantage of facilitating release of the base material 20 and supports 11a, 12a during connection.

The material used for the supports 11a, 12a may be the same material used for the base material 20. From the viewpoint of releasability between the support and adhesive layer, the surface of the side of the support on which the adhesive layer is formed is preferably subjected to release treatment such as silicone treatment.

The adhesive layers 11b, 12b formed on the sides of the supports 11a, 12a are films of an adhesive composition. Each adhesive layer may have a monolayer structure or a laminated structure composed of a plurality of layers, which may correspond to the shape of the circuit member or circuit electrode which is to be connected. The thickness of the adhesive layer is not particularly restricted and may be appropriately selected depending on the adhesive composition used and the shape of the electrode to be connected, but it is preferably 5-100 µm. The width of the adhesive layer is also not particularly restricted and may be appropriately selected depending on the adhesive composition used and the shape of the electrode to be connected, but it is preferably 0.5-5 mm. According to this embodiment, the adhesive layers 11b, 12b are formed across the entire region in the widthwise direction of the supports 11a, 12a, respectively. The width of the support 11a is therefore equal to the width of the adhesive layer 11b, and the width of the support 12a is equal to the width of the adhesive layer 12b.

As explained hereunder, the adhesive layer 11b has a construction suitable for COG mounting of a driver IC, while the adhesive layer 12b has a construction suitable for FOG mounting of an FPC. The adhesive layers 11b, 12b are constructed of different types of adhesive compositions, as will also be explained hereunder.

The adhesive layer 11b for COG mounting of a driver IC on a LCD glass panel has a laminated structure comprising a first layer 111 and a second layer 112. The first layer 111 is composed of an adhesive composition containing a thermosetting resin. The second layer 112 is composed of an adhesive composition that comprises a thermosetting resin-containing adhesive component and conductive particles 31 dispersed therein. The first layer 111 is formed in contact with the support 11a, and the second layer 112 is laminated over the first layer 111.

The adhesive composition composing the first layer 111 may be any of numerous materials that are curable by heat or light. Crosslinkable materials are preferably used for more excellent heat resistance and humidity resistance after connection. Epoxy-based adhesives that contain thermosetting epoxy resins as their major components are particularly preferred because they can be cured within a shorter period of time and thus improve connection manageability, while their adhesion is also superior based on their molecular structure. Epoxy-based adhesives that may be used include, for example, high molecular weight epoxy compounds, solid epoxy compounds and liquid epoxy compounds, or such compounds having epoxy as the main component and modified with urethane, polyester, acrylic rubber, nitrile rubber, nylon or the like. Epoxy-based adhesives generally include additives such as curing agents, catalysts, coupling agents, fillers and the like in addition to the main epoxy component.

The adhesive composition composing the first layer 111 preferably contains a component that has a property of alleviating internal stress produced by COG mounting. Silicone fine particles may be mentioned as a component with a property of alleviating internal stress. Using such an adhesive composition can minimize warping of the glass panel that occurs due to differences in the linear expansion coefficients of the LCD glass panel (glass) and the driver IC.

The adhesive composition composing the second layer 112 has conductive particles 31 dispersed in an adhesive component made of the same components as the adhesive composition of the first layer 111. As examples of conductive particles 31 there may be mentioned particles of metals such as Au, Ag, Pt, Ni, Cu, W, Sb, Sn and solder, or carbon particles. Alternatively, covered particles comprising non-conductive glass, ceramic, plastic or the like may be used as a core and covered with the aforementioned metals or carbon. The mean particle size of the conductive particles is preferably 1-18 µm from the viewpoint of dispersibility and conductivity. Insulating coating particles comprising conductive particles coated with an insulating layer may also be used, and conductive particles may even be used in combination with insulating particles, from the viewpoint of improving the insulating property between adjacent electrodes.

The mixing proportion of the conductive particles 31 is preferably 0.1-30 parts by volume and more preferably 0.1-10 parts by volume with respect to 100 parts by volume of the adhesive component in the second layer 112. If the mixing proportion is less than 0.1 part by volume the connection resistance between opposing electrodes will tend to be higher, and if it is greater than 30 parts by volume there will tend to be more shorting between adjacent electrodes.

If the adhesive layer 11b has the laminated structure described above, it will be possible to concentrate the conductive particles 31 within the LCD glass panel side of the adhesive layer 11b. This will help restrict flow of the conductive particles during connection. As a result, the conductive particles 31 will be more reliably captured between the circuit electrodes of the LCD glass panel and the terminals (circuit electrodes) of the driver IC.

On the other hand, the adhesive layer 12b which is used for FOG mounting of an FPC on the LCD glass panel has a monolayer structure. The adhesive composition composing the adhesive layer 12b has conductive particles 32 dispersed in an adhesive component composed mainly of a thermosetting resin. The thermosetting resin used may be the same type as in the adhesive composition of the first layer 111 of the adhesive layer 11b. From the viewpoint of improving adhesion with the FPC, the adhesive composition composing the adhesive layer 12b preferably contains an acrylic rubber or elastomer component.

The conductive particles 32 dispersed in the adhesive layer 12b may be the same as the aforementioned conductive particles 31. The mixing proportion of the conductive particles 32 is preferably 0.1-30 parts by volume and more preferably 0.1-10 parts by volume with respect to 100 parts by volume of the adhesive component in the adhesive layer 12b. If the mixing proportion is less than 0.1 part by volume the connection resistance between opposing electrodes will tend to be higher, and if it is greater than 30 parts by volume there will tend to be more shorting between adjacent electrodes.

### (Process for production of anisotropic conductive tape)

A process for production of the anisotropic conductive tape 1A will now be explained. For production of the anisotropic conductive tape 1A, the adhesive layer elements 11, 12 are prepared first (element preparation step). The pressure-sensitive adhesive layer 20a is formed as a film on the main side 21 of the tape-like base material 20 to a greater width than the total width of the adhesive layer elements 11, 12 (base material tape preparation step). The adhesive layers 11b, 12b of the adhesive layer elements 11, 12 and the pressure-sensitive adhesive layer 20a of the base material 20 are formed using a conventional known coating applicator.

Next, the adhesive layer elements 11, 12 are held over the pressure-sensitive adhesive layer 20a in such a manner that the pressure-sensitive adhesive layer 20a and the supports 11a, 12a of the adhesive layer elements 11, 12 are oriented facing each other. The adhesive layer elements 11, 12 are then anchored to the base material 20 in such a manner that the adhesive layer elements 11, 12 extend along the lengthwise direction of the base material 20 and are anchored in parallel on the pressure-sensitive adhesive layer 20a (element anchoring step).

The production process described above is suitable for production of anisotropic conductive tapes with relatively short lengths (≤50 cm), but when the length of the anisotropic conductive tape to be produced is longer than 50 cm, it becomes difficult to manage the adhesive layer elements 11, 12 and base material 20 having equivalent lengths. The anisotropic conductive tape 1A may therefore be produced using the adhesive layer elements 11, 12 or base material 20 wound on reels. The anisotropic conductive tape 1A obtained as the final product may also be wound on a reel.

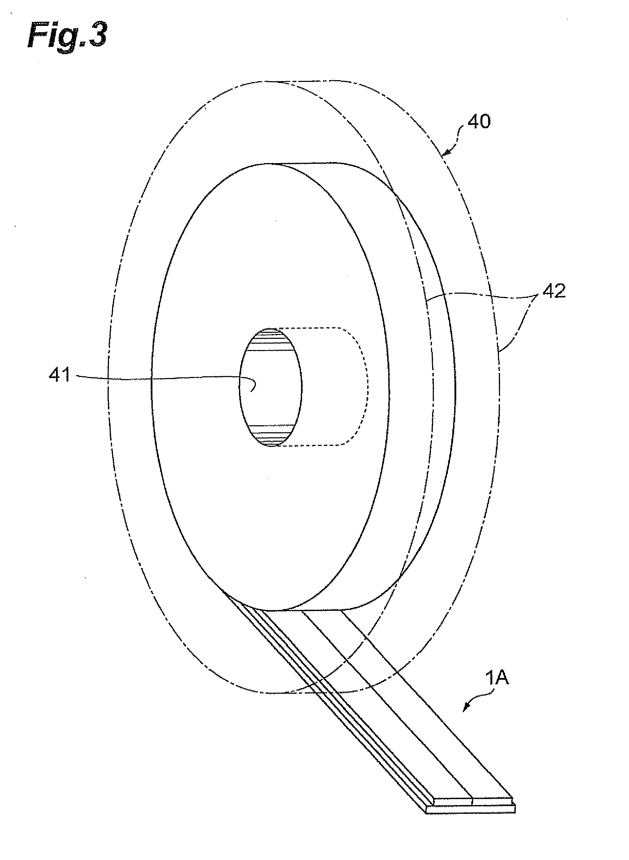

Fig. 3 is a perspective view showing an anisotropic conductive tape 1A wound onto a reel. As shown in Fig. 3, the anisotropic conductive tape 1A is wound on a reel 40 consisting of side plates 42 on both sides of a winding core 41. Winding the anisotropic conductive tape 1A around a reel 40 can improve the manageability of the anisotropic conductive tape 1A.

For production of a rolled anisotropic conductive tape 1A, first the adhesive layer elements 11, 12 are each wound onto a reel to prepare rolled elements 11A, 12A (rolled element preparation step). The rolled elements 11 A, 12A may be produced by cutting their respective sheets (10-50 cm widths) to prescribed widths and winding them around winding cores. The sheets for the rolled elements 11A, 12A can be produced by forming the adhesive layers 11b, 12b on the support film sheet using a conventionally known coating applicator such as a roll coater.

The pressure-sensitive adhesive layer 20a, on the other hand, is formed on the main side 21 of the base material 20 to a greater width than the total width of the adhesive layer elements 11, 12, and this is wound up on a reel to prepare a rolled base material tape 20A (rolled base material tape preparation step). The rolled base material tape 20A may be produced, for example, by cutting the sheet to a prescribed width and winding it around a winding core. The sheet for the rolled base material tape 20A can be produced by forming a pressure-sensitive adhesive layer 20a on a base material film sheet using a conventionally known coating applicator such as a roll coater.

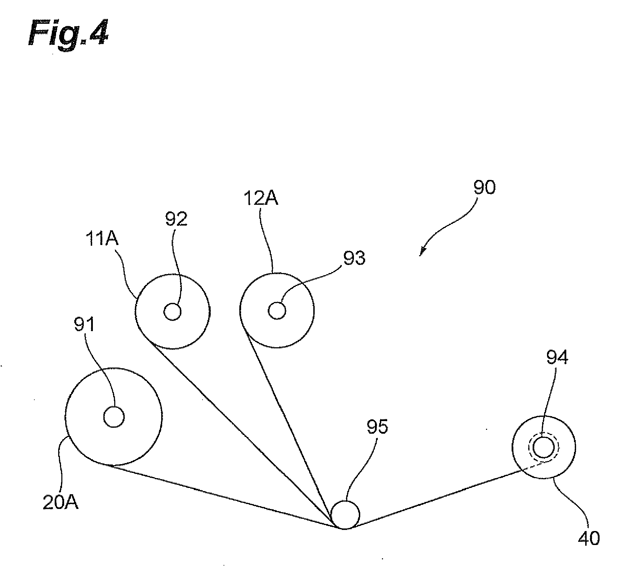

The rolled base material tape 20A and rolled elements 11A, 12A prepared in the manner described above are mounted on a winding apparatus 90 as shown in Fig. 4. The winding apparatus 90 comprises rotation axes 91, 92, 93 that engage in a freely rotatable manner with the aforementioned three rolled bodies, a rotation axis 94 that engages in a freely rotatable manner with the anisotropic conductive tape 1A take-up reel 40, and a roller 95 situated between the rotation axes 91, 92, 93 and the rotation axis 94.

After the rolled elements 11A, 12A, rolled base material tape 20A and reel 40 have been mounted on the winding apparatus 90, the starting edges of the adhesive layer elements 11, 12 and the base material 20 are pulled out. The starting edges of the adhesive layer elements 11, 12 are placed and anchored in parallel on the pressure-sensitive adhesive layer 20a at the starting edge of the base material 20. The starting edges of each are anchored together in such a manner that the adhesive layer elements 11, 12 are matched in the lengthwise direction of the base material 20 and the pressure-sensitive adhesive layer 20a and the supports 11a, 12a of the adhesive layer elements 11, 12 are in contact.

The starting edge of each rolled body that has been anchored together is pulled out and fixed on a reel 40 via a roller 95. The side on which the adhesive layer elements 11, 12 are situated is contacted with the surface of the roller 95. The reel 40 is rotated while pressing force applied by the roller 95 anchors the adhesive layer elements 11, 12 in the lengthwise direction of the base material 20, to wind the anisotropic conductive tape 1A onto the reel 40 (rolled body fabrication step). The pressing force of the roller 95 can be adjusted by controlling the tension on the base material 20 and the adhesive layer elements 11, 12, or in other words, by controlling the feeding speed of the base material 20 and the adhesive layer elements 11, 12 and their wind-up speed onto the reel 40.

Since the adhesive layer elements 11, 12 are anchored onto the pressure-sensitive adhesive layer 20a of the base material 20 without releasing the supports 11a, 12a, it is possible in this production process to improve strength in the lengthwise direction of the anisotropic conductive tape 1A. With sufficiently high strength in the lengthwise direction of the anisotropic conductive tape 1A, it is possible to adequately prevent inconveniences such as breakage along the anisotropic conductive tape 1A during the rolled body fabrication step and the mounting operation.

A conventionally known anisotropic conductive film that is commercially available in a form wound around a reel as a rolled element may be used for the production process of this embodiment, so long as the adhesive layer is formed on the main side of the support. The conventionally known anisotropic conductive film may be used directly in that form or cut to the desired width in the lengthwise direction, for effective use as an adhesive layer element.

The production process of this embodiment has the further advantage of minimizing increased cost for equipment investment. The sheet for a conventionally known anisotropic conductive film that is commercially available in a form wound on a reel is usually produced by pulling out a sheet such as a PET film while forming an adhesive layer made of an adhesive composition on the surface thereof, and then re-winding it up. The anisotropic conductive film sheet produced in this manner is then cut to the desired width and re-wound onto a reel to produce the anisotropic conductive tape. Since the production process of this embodiment allows effective application of the apparatuses used for the cutting step or take-up step of a conventional anisotropic conductive tape production process, it is possible to minimize additional cost for equipment investment.

### (Method of using anisotropic conductive tape)

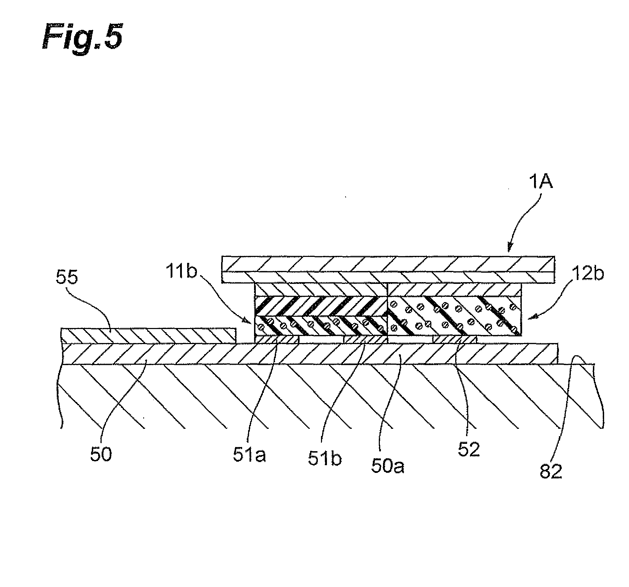

A method of using the anisotropic conductive tape 1A will now be explained, with reference to Figs. 5 to 9. In this method, specifically, a driver IC 60 and FPC 70 are bonded onto the perimeter 50a of an LCD glass panel 50 using the anisotropic conductive tape 1A, to establish electrical connection.

As shown in Fig. 5, a color filter 55 is provided at the center of the glass panel 50. A plurality of electrodes 51a, 51b and an electrode 52 are provided at the perimeter 50a of the glass panel 50, situated parallel along the lengthwise direction of the perimeter 50a. The electrodes 51a, 51 b are connected to respective terminals (circuit electrodes) of the driver IC 60. The electrode 52 is connected to an electrode of the FPC 70.

First, the glass panel 50 is placed on the support stage 82 of a pressing apparatus. The anisotropic conductive tape 1A that has been cut to the desired length is placed along the lengthwise direction of the perimeter 50a covering the electrodes 51a, 51b and the electrode 52. Here, the anisotropic conductive tape 1A is situated in such a manner that the electrodes 51a, 51b are in contact with the adhesive layer 11b and the electrode 52 is in contact with the adhesive layer 12b.

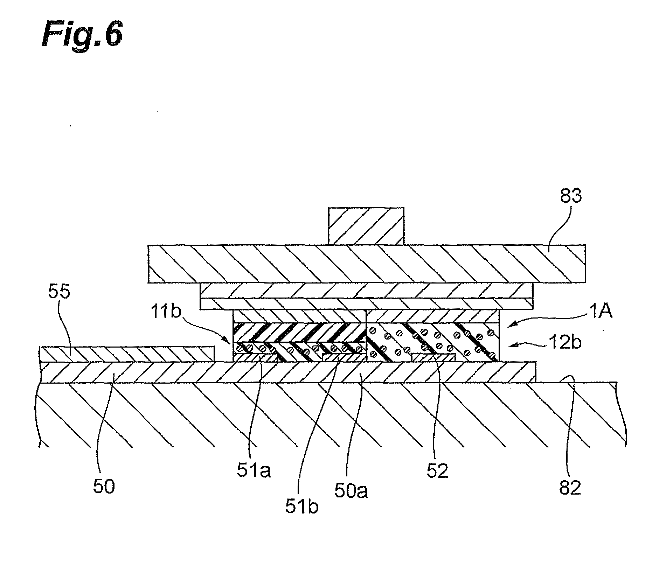

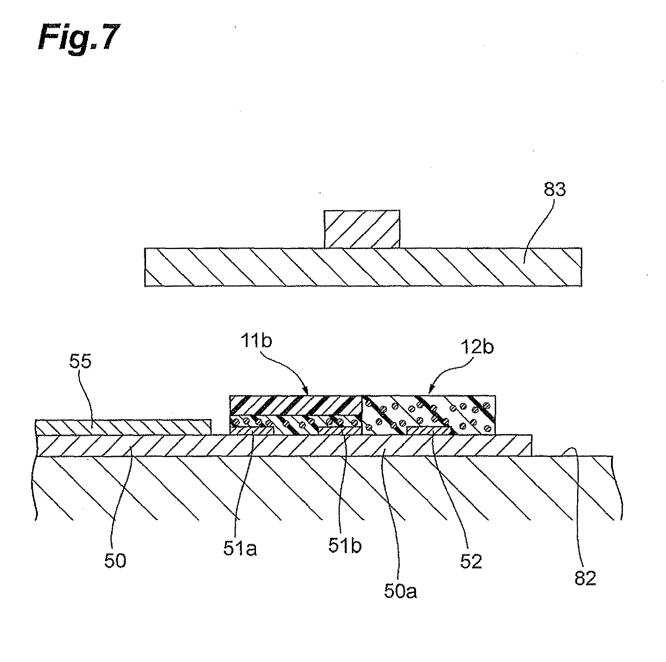

Next, a thermal pressing head 83 is moved downward toward the glass panel 50 for preliminary contact bonding of the anisotropic conductive tape 1A to the glass panel 50, as shown in Fig. 6. This anchors the adhesive layers 11b, 12b onto the glass panel 50 so that they cover the electrodes 51a, 51b and the electrode 52. The thermal pressing head 83 is then withdrawn upward. The base material 20 and supports 11a, 12a are then released together (see Fig. 7).

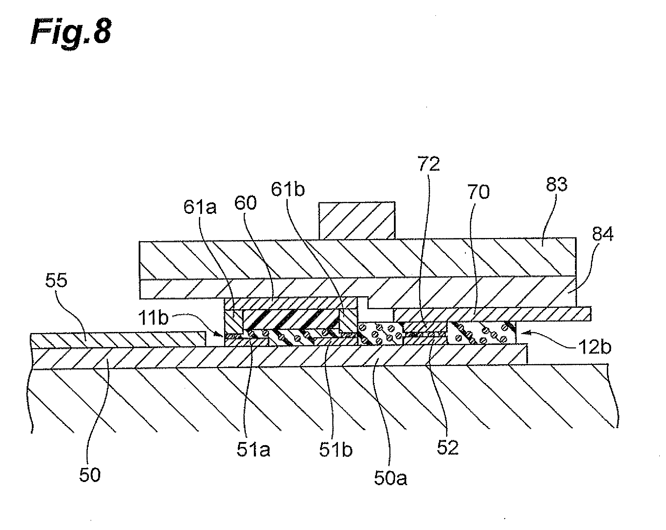

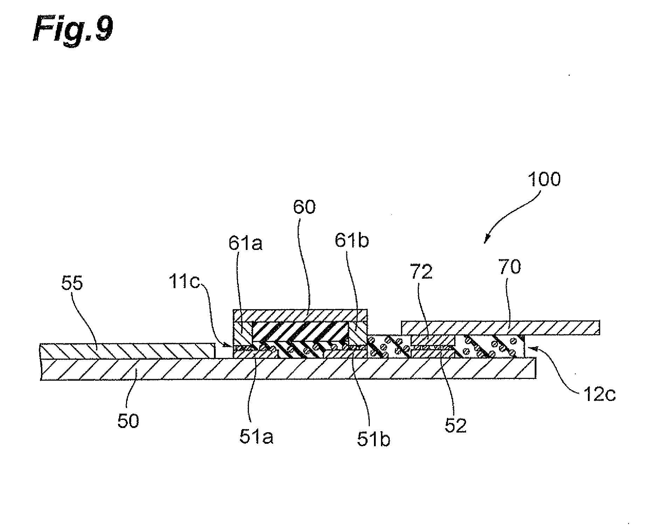

Next, as shown in Fig. 8, the driver IC 60 and FPC 70 are each adhesively anchored to the glass panel 50. Specifically, the driver IC 60 is set on the adhesive layer 11b which is anchored on the glass panel 50, while the FPC 70 is set on the adhesive layer 12b. The positions are adjusted so that the terminals 61 a, 61b of the driver IC 60 respectively oppose the electrodes 51a, 51b of the glass panel 50. Similarly, the position of the FPC 70 is adjusted so that the electrode 72 opposes the electrode 52 of the glass panel 50. The thermal pressing head 83 is then moved downward toward the driver IC 60 and FPC 70 for thermal pressing of the entire assembly through a polytetrafluoroethylene material 84 as a cushion material, as shown in Fig. 8. This cures the adhesive layers 11b, 12b to produce a connection structure as shown in Fig. 9.

When the heights of the driver IC 60 and FPC 70 differ, the thickness of the polytetrafluoroethylene material 84 may be appropriately adjusted at the sections where pressing force is applied to the driver IC 60 and FPC 70 for suitable pressure application to both the driver IC 60 and FPC 70.

In the connection structure 100 shown in Fig. 9, the glass panel 50 and the driver IC 60 and FPC 70 are connected via the cured products 11c, 12c of the adhesive layers 11b, 12b, respectively. In the connection structure 100, the terminals 61a, 61b of the driver IC 60 opposing the electrodes 51a, 51b of the glass panel 50 are each electrically connected via conductive particles. Similarly, the electrode 52 of the glass panel 50 is also electrically connected to the opposing electrode 72 of the FPC 70 via conductive particles.

Since the anisotropic conductive tape of this embodiment is provided with two adhesive layers, it is possible to simultaneously carry out the anchoring procedure (positioning and preliminary contact bonding) for the adhesive layer for the driver IC and FPC. The connecting operation for the driver IC and FPC may also be carried out simultaneously after each adhesive layer has been anchored onto the glass panel 50. That is, according to this embodiment, the COG mounting and FOG mounting of an LCD module fabrication step may be carried out simultaneously. Consequently, the number of steps for connection of each circuit member can be reduced, thus improving the throughput.

Moreover, since connection operation can be carried out sufficiently even in narrow spaces with the anisotropic conductive tape of this embodiment, it is possible to connect multiple circuit members to LCD glass panels with narrow frames.

### (Second embodiment)

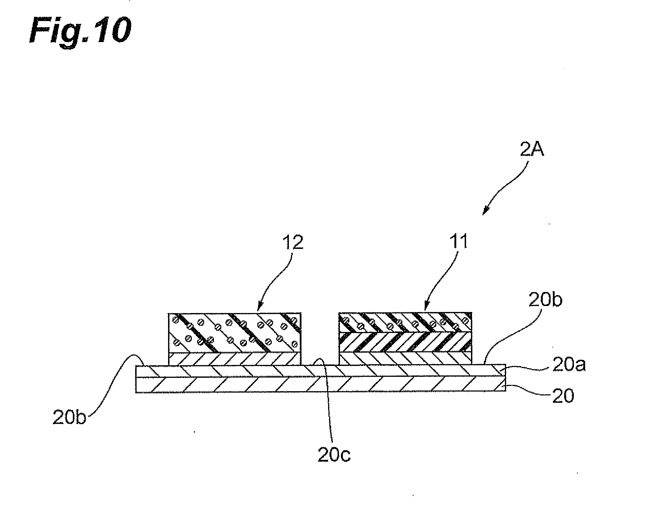

A second embodiment of an anisotropic conductive tape according to the invention will now be explained. Fig. 10 is a cross-sectional view of the anisotropic conductive tape 2A of this embodiment in the widthwise direction. The anisotropic conductive tape 2A is provided with mutually isolated adhesive layer elements 11, 12 on a base material 20, and it has the same construction as the anisotropic conductive tape 1A of the first embodiment except that a base material-exposed section 20c lacking the adhesive layer is provided between the adhesive layer elements 11, 12. The base material-exposed section 20c is located between the adhesive layers 11b, 12b and extends along the lengthwise direction of the base material 20. Providing the base material-exposed section 20c increases the degree of freedom of design of the connectable circuit members, while also allowing connection of driver ICs or FPCs with different shapes. The amount of adhesive composition used can also be reduced.

### (Third and fourth embodiments)

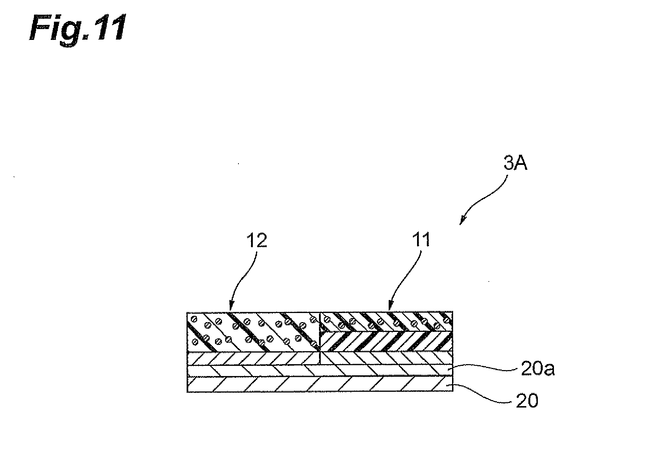

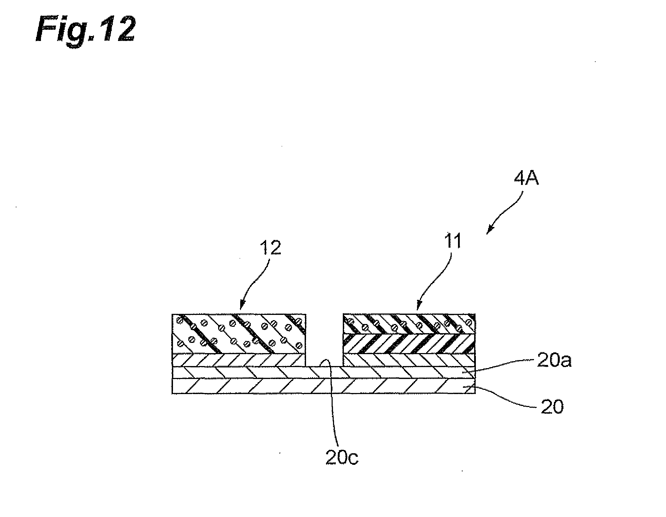

Figs. 11 and 12 are widthwise cross-sectional views of third and fourth embodiments of an anisotropic conductive tape according to the invention. The anisotropic conductive tape 3A shown in Fig. 11 has the same construction as the anisotropic conductive tape 1A of the first embodiment, except that the total length of the widths of the adhesive layer elements 11, 12 is equal to the width of the base material 20. The anisotropic conductive tape 4A shown in Fig. 12, on the other hand, has the same construction as the anisotropic conductive tape 2A of the second embodiment, except that the positions are at both edges in the widthwise direction of the base material 20, and it lacks base material-exposed sections 20b extending along the lengthwise direction of the base material 20.

### (Fifth embodiment)

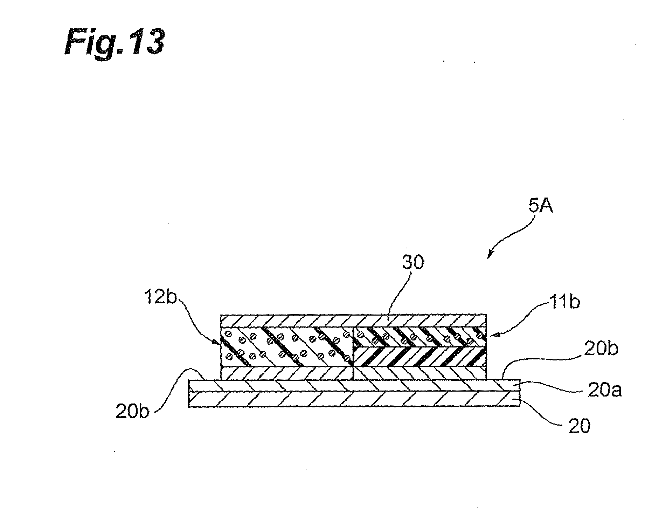

Fig. 13 is a widthwise cross-sectional view showing a fifth embodiment of an anisotropic conductive tape according to the invention. The anisotropic conductive tape 5A shown in Fig. 13 has the same construction as the anisotropic conductive tape 1A of the first embodiment, except that it is provided with a tape-like protective material 30 covering the surface of the adhesive layers 11b, 12b. If the tape is stored with the surfaces of the adhesive layers 11b, 12b covered by the protective material 30 which is released immediately before use, it is possible to prevent adhesion of moisture or foreign matter such as dust in the air onto the adhesive layers 11b, 12b and thus minimize deterioration of the adhesive layers 11b, 12b.

### (Sixth embodiment)

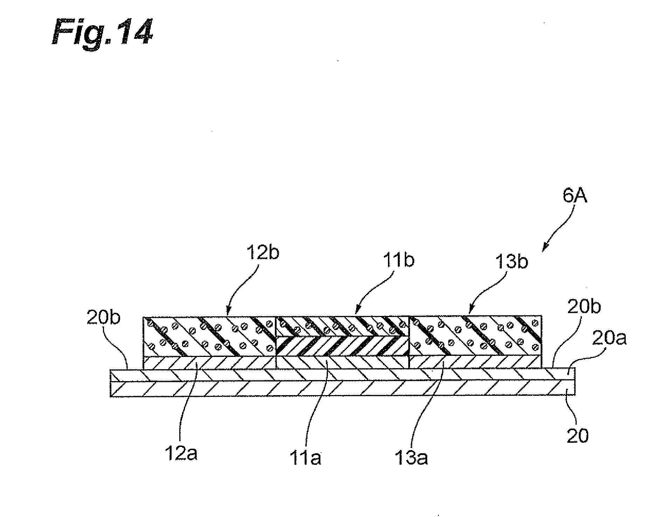

Fig. 14 is a widthwise cross-sectional view showing a sixth embodiment of an anisotropic conductive tape according to the invention. The anisotropic conductive tape 6A shown in Fig. 14 has the same construction as the anisotropic conductive tape 1A of the first embodiment, except that three adhesive layers 11b, 12b, 13b are provided on the main side of the base material 20. The adhesive layers 11b, 12b, 13b are situated on the base material 20 via respective supports 11a, 12a, 13a, and they are parallel on the pressure-sensitive adhesive layer 20a of the base material 20, extending along the lengthwise direction of the base material 20. This type of anisotropic conductive tape 6A allows each circuit member to be connected to the adhesive layers 11b, 12b, 13b that have been transferred onto the circuit board, so that a total of three circuit members can be connected.

In this anisotropic conductive tape 6A, both edge sides of the adhesive layer 11b are in contact with the edge sides of the adhesive layers 12b, 13b, but at least one pair of adjacent adhesive layers may instead be formed in isolation from each other. The width of the base material-exposed section lacking the adhesive layer, that is formed between the adhesive layers formed in isolation, may be the same as or different from the width of the base material-exposed sections 20b on either side in the widthwise direction of the base material 20.

As mentioned above, the number of adhesive layers formed in parallel on the base material 20 may be 2, 3, 4 or more layers. However, from the viewpoint of manageability for connection and ease of fabrication, the number of adhesive layers formed on one anisotropic conductive tape is preferably 2-5, and more preferably 2-3.

### (Seventh to twelfth embodiments)

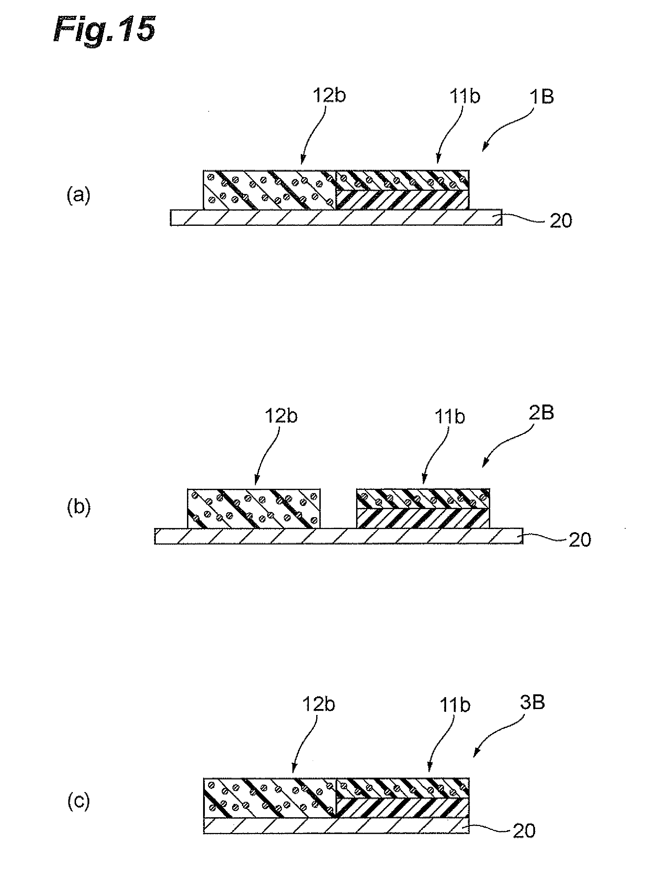

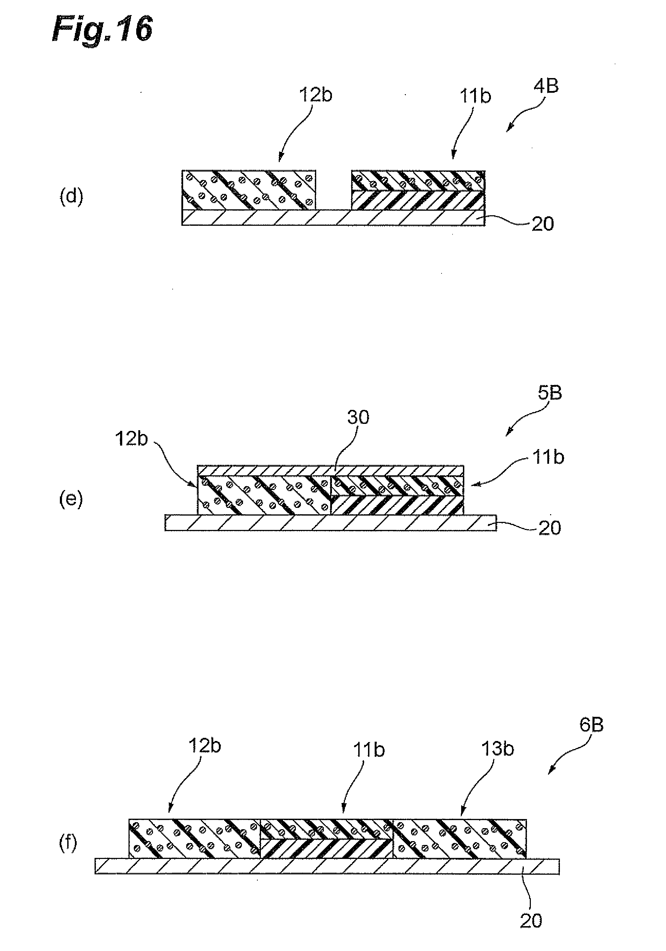

Fig. 15(a)-(c) are widthwise cross-sectional views showing seventh to ninth embodiments of an anisotropic conductive tape according to the invention. Fig. 16(d)-(f) are widthwise cross-sectional views showing tenth to twelfth embodiments of an anisotropic conductive tape according to the invention. The anisotropic conductive tapes 1B-6B shown in Fig. 15 and Fig. 16 have the same construction as the anisotropic conductive tapes 1A-6A of the first to sixth embodiments, except that no support (11a, 12a, 13a) or pressure-sensitive adhesive layer 20a are provided, and the adhesive layers 11b, 12b, 13b are formed directly on the base material 20. The anisotropic conductive tapes 1B-6B may be fabricated by placing the base material 20 and adhesive layers in contact when anchoring each adhesive layer element onto the base material 20, and then releasing the support. The tapes may also be stored with the unreleased support, which is released just before use.

The invention was explained by the embodiments described above, but it is in no way limited to those embodiments. The invention may also be applied in a variety of other forms mentioned below, so long as the gist thereof is maintained. For example, the embodiments assumed production of an LCD module, but the anisotropic conductive tape of the invention is not limited to an LCD module and may be used instead for production of an image display device such as a plasma display or EL display, or a semiconductor device.

Also, the embodiments described above are anisotropic conductive tapes having adhesive layers with roughly the same width formed on the base material, but the widths of the adhesive layers may be appropriately selected based on the shape of the circuit members to be connected. The width of the base material-exposed section lacking the adhesive layer may also be appropriately selected. By appropriately selecting these widths it is possible to connect circuit members of different types (shapes and sizes) with the adhesive tape of the invention. Moreover, although the embodiments described above are anisotropic conductive tapes having adhesive layers with roughly the same thickness formed on the base material, the thicknesses of the adhesive layers may be appropriately designed based on the shape of the circuit members to be connected.

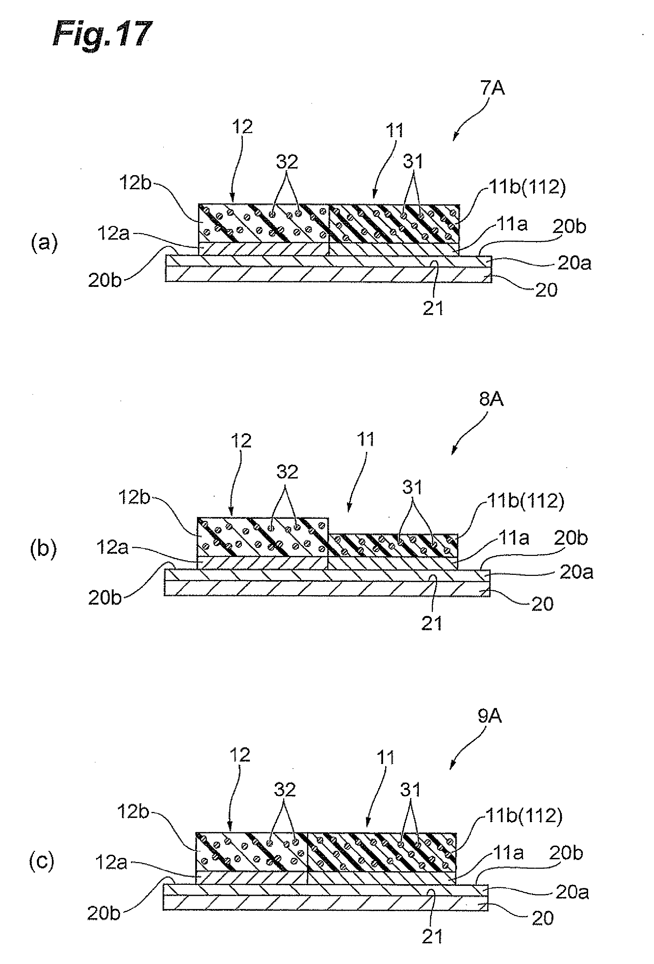

The anisotropic conductive tapes of embodiments 1-12 all have bilayer laminated structures for the adhesive layer 11b, but the adhesive layer 11b may instead have a monolayer structure consisting of a single layer. In such cases, however, the adhesive layer 11b is preferably composed of an adhesive composition that is different from the adhesive composition composing the adhesive layer 12b. A different adhesive composition means that it has different adhesive components or a different conductive particle content. The anisotropic conductive tape 7A shown in Fig. 17(a) has the same construction as the anisotropic conductive tape 1A of the first embodiment, except that the adhesive layer 11b has a monolayer structure.

The anisotropic conductive tape 8A shown in Fig. 17(b) has the same construction as the anisotropic conductive tape 7A, except that the thicknesses of the adhesive layers are different. Also, the anisotropic conductive tape 9A shown in Fig. 17(c) has the same construction as the anisotropic conductive tape 7A, except that the widths of the adhesive layers are different.

### Industrial Applicability

The anisotropic conductive tape of the invention has multiple adhesive layers formed in parallel on a base material, and by adapting the construction of each adhesive layer to the circuit members it is possible to mount multiple circuit members on a circuit board by a single anisotropic conductive tape. Thus, while mounting of multiple circuit members (for example, a driver IC and FPC) on a circuit board has required an operation for preattachment of a connecting member at the location where each circuit member is to be bonded, the anisotropic conductive tape of the invention allows mounting of multiple circuit members at their locations simply by attaching the tape once. This connection of the multiple circuit members can also be carried out in a single operation. Thus, the anisotropic conductive tape of the invention contributes to improved production efficiency for circuit connection structures.

The anisotropic conductive tape of the invention may also have a construction with a COG mounting adhesive layer and an FOG mounting adhesive layer formed in parallel. This type of construction allows attachment of two adhesive layers in limited space even if the perimeter of the circuit board is narrow, thus permitting more efficient COG mounting and FOG mounting.

## Claims

1. An anisotropic conductive tape comprising:
a tape-like base material; and
multiple adhesive layers formed in parallel on the main side of the base material and extending along the lengthwise direction of the base material;
wherein the anisotropic conductive tape is used for electrical connection between opposing circuit electrodes, and at least two of the multiple adhesive layers have different constructions.

2. The anisotropic conductive tape according to claim 1, wherein the said construction is at least one selected from the group consisting of its thickness and its adhesive composition.

3. The anisotropic conductive tape according to claim 1, wherein the said construction is the width in the widthwise direction.

4. The anisotropic conductive tape according to claim 1, wherein at least one of the multiple adhesive layers has a laminated structure comprising a plurality of laminated layers, and at least one of the multiple adhesive layers has a monolayer structure composed of a single layer.

5. The anisotropic conductive tape according to any one of claims 1 to 4, wherein each adhesive layer is formed on a tape-like support, and the multiple adhesive layers are formed on the main side of the base material through the support.

6. The anisotropic conductive tape according to any one of claims 1 to 5, wherein the adhesive composition in each adhesive layer comprises an adhesive component and conductive particles dispersed in the adhesive component.

7. The anisotropic conductive tape according to any one of claims 1 to 6, wherein the base material has a width that is equal to or greater than the total width of the multiple adhesive layers.

8. The anisotropic conductive tape according to any one of claims 1 to 7, having first base material-exposed sections consisting of regions without adhesive layer formation, on the surface of the side of the base material on which the adhesive layers have been formed,
wherein the first base material-exposed sections are situated at both edges in the widthwise direction of the base material and extend along the lengthwise direction of the base material.

9. The anisotropic conductive tape according to claim 8, wherein the first base material-exposed sections situated at both edges in the widthwise direction of the base material have different widths.

10. The anisotropic conductive tape according to any one of claims 1 to 9, having second base material-exposed sections consisting of regions without adhesive layer formation, on the surface of the side of the base material on which the adhesive layers have been formed, and at least one pair of adjacent adhesive layers are formed in mutual isolation,
wherein the second base material-exposed sections are situated between the pair of adhesive layers and extend along the lengthwise direction of the base material.

11. The anisotropic conductive tape according to any one of claims 1 to 10, further comprising a tape-like protective material formed covering the surfaces of the multiple adhesive layers.

12. The anisotropic conductive tape according to any one of claims 1 to 11, wherein the multiple adhesive layers are two adhesive layers.

13. The anisotropic conductive tape according to claim 12, wherein of the two adhesive layers, one is for COG mounting and the other is for FOG mounting.

14. A process for production of an anisotropic conductive tape comprising steps of:
an element preparation step in which a plurality of adhesive layer elements are prepared each comprising a tape-like support and an adhesive layer formed on the main side of the support;
a base material tape preparation step in which a base material tape is prepared comprising a tape-like base material with a width equal to or greater than the total of the widths of the multiple adhesive layer elements, and a pressure-sensitive adhesive layer formed on the main side of the base material; and
an element anchoring step in which the multiple adhesive layer elements are placed and anchored on the pressure-sensitive adhesive layer in such a manner that the pressure-sensitive adhesive layer is oriented in contact with the back side of the support and each of the adhesive layers extends in the lengthwise direction of the pressure-sensitive adhesive layer.

15. A process for production of an anisotropic conductive tape comprising steps of:
a rolled element preparation step in which a plurality of rolled elements are prepared, each obtained by rolling around a core an adhesive layer element comprising a tape-like support and an adhesive layer formed on the main side of the support;
a rolled base material tape preparation step in which a rolled base material tape is prepared, obtained by rolling around a core a base material tape comprising a tape-like base material with a width equal to or greater than the total of the widths of the multiple adhesive layer elements, and a pressure-sensitive adhesive layer formed on the main side of the base material; and
a rolled body fabrication step in which the starting edges of the plurality of rolled elements and the rolled base material tape are pulled out and the multiple adhesive layer elements are wound around a core while anchoring them on the base material tape, in such a manner that the pressure-sensitive adhesive layer and back side of the support are oriented in contact, with each of the adhesive layer elements extending in parallel in the lengthwise direction of the base material tape.

16. A connection structure comprising:
a first circuit member having a plurality of first circuit electrodes formed on its main side;
a plurality of second circuit members each provided with a second circuit electrode to be connected to the plurality of first circuit electrodes, on the surface facing the first circuit member; and
a connecting member formed between the first circuit member and the plurality of second circuit members;
wherein the connecting member is composed of cured adhesive layers of an anisotropic conductive tape according to any one of claims 1 to 11, the cured layers being cured by heat pressurization of each adhesive layer while they are situated between the first circuit member and the plurality of second circuit members, and it establishes electrical connection between the opposing first circuit electrodes and second circuit electrodes.

17. A connection structure comprising:
a circuit board having first and second circuit electrodes formed on the main side;
a first circuit member provided with a third circuit electrode opposing the first circuit electrode on the side facing the circuit board;
a second circuit member provided with a fourth circuit electrode opposing the second circuit electrode on the side facing the circuit board;
a first connecting member provided between the circuit board and the first circuit member that forms an electrical connection between the first circuit electrode and third circuit electrode; and
a second connecting member provided between the circuit board and the second circuit member that forms an electrical connection between the second circuit electrode and fourth circuit electrode;
wherein the first connecting member is composed of the cured product of one of the adhesive layers of an anisotropic conductive tape according to claim 12, and
the second connecting member is composed of the cured product of the other adhesive layer of the anisotropic conductive tape according to claim 12.

18. A connection structure comprising:
a circuit board having first and second circuit electrodes formed on the main side;
a semiconductor chip provided with a third circuit electrode opposing the first circuit electrode on the side facing the circuit board;
a flexible printed circuit board provided with a fourth circuit electrode opposing the second circuit electrode on the side facing the circuit board;
a first connecting member provided between the circuit board and the semiconductor chip that forms an electrical connection between the first circuit electrode and third circuit electrode; and
a second connecting member provided between the circuit board and the flexible printed circuit board that forms an electrical connection between the second circuit electrode and fourth circuit electrode;
wherein the first connecting member is composed of the cured product of the COG mounting adhesive layer of an anisotropic conductive tape according to claim 13, and
the second connecting member is composed of the cured product of the FOG mounting adhesive layer of an anisotropic conductive tape according to claim 13.

19. A circuit member connection method, wherein
one adhesive layer of an anisotropic conductive tape according to any one of claims 1 to 11 is situated between a first circuit member with a plurality of first circuit electrodes formed on its main side and each of a plurality of second circuit members which are provided with respective second circuit electrodes that are to be connected to the plurality of first circuit electrodes, on the side facing the first circuit member,
and the stack is heated and pressed to cure each adhesive layer, thereby bonding the first circuit member with the plurality of second circuit members in such a manner that the first circuit electrodes and second circuit electrodes are electrically connected.

20. A circuit member connection method, wherein
one adhesive layer of an anisotropic conductive tape according to claim 12 is situated between a circuit board having first and second circuit electrodes formed on the main side, and a first circuit member provided with a third circuit electrode opposing the first circuit electrode on the side facing the circuit board and a second circuit member provided with a fourth circuit electrode opposing the second circuit electrode on the side facing the circuit board,
and the stack is heated and pressed to cure each adhesive layer, thereby bonding the circuit board with the first and second circuit members in such a manner that the first circuit electrode and third circuit electrode are electrically connected and the second circuit electrode and fourth circuit electrode are electrically connected.

21. A circuit member connection method, wherein
the COG mounting adhesive layer and the FOG mounting adhesive layer of an anisotropic conductive tape according to claim 13 is situated between a circuit board having first and second circuit electrodes formed on the main side, and a semiconductor chip provided with a third circuit electrode opposing the first circuit electrode on the side facing the circuit board and a flexible printed circuit board provided with a fourth circuit electrode opposing the second circuit electrode on the side facing the circuit board,
and the stack is heated and pressed to cure each adhesive layer, thereby bonding the circuit board with the semiconductor chip and the flexible printed circuit board in such a manner that the first circuit electrode and third circuit electrode are electrically connected and the second circuit electrode and fourth circuit electrode are electrically connected.
